# EUROPEAN PATENT APPLICATION

(11) **EP 4 429 270 A1**
(43) Date of publication of application: **11.09.2024**
(21) Application number: 24153123.5
(22) Date of filing: 22.01.2024
(51) Int. Cl.: H04R 1/12, H04R 25/00, B05D 1/00, B05D 5/08

(54) **A HEARING INSTRUMENT WITH IMPROVED CORROSION PROTECTION**

(30) Priority: 13.02.2023 EP 23156250
(71) Applicant: Oticon A/S, 2765 Smørum (DK)
(72) Inventor: STACHURSKI, Grzegorz, 72-006 Mierzyn (PL)
(74) Representative: Demant

(57) **Abstract**

Disclosed herein is a hearing instrument. The hearing instrument has improved corrosion protection. The hearing instrument can include a substrate. The hearing instrument can include a coating at least partially covering the substrate, the coating comprising at least two sets of alternating layers, a first layer of the alternating layers comprising a first material and a second layer of the alternating layers comprising a second material. The first material can include a dielectric material. The second material includes a hydrophobic material.

## Description

### SUMMARY

### A hearing instrument:

In an aspect of the present application, a hearing instrument is provided. The hearing instrument includes a substrate. The hearing instrument includes a coating. The coating can at least partially cover the substrate. The coating can include at least two sets of alternating layers. The first layer of the alternating layers can include a first material. A second layer of the alternating layers can include a second material. The first material includes a dielectric material. The second material includes a hydrophobic material.

Advantageously, the hearing instrument may have high corrosion protection via the coating (e.g., barrier). In particular, it is advantageous for components of the hearing instrument, such as metal and/or electronic parts, to have protection against human secretions like ear wax, sebum, sweat, but also environmental humidity and occasional water splashes. Ingress of all of these substances under protective plastic shell cause corrosion on metallic and/or electronical assemblies of hearing instrument, eventually causing the instrument to break and/or stop functioning. The disclosed improved coating can prevent ingress of such substances, therefore increasing the longevity of the hearing instrument.

In certain examples, the hearing instrument introduces increased functionality and performance via a coating having reduced physical and chemical permeability. By having a coating with an increased number of layers, there similarly occurs an increased number of borders between phases (e.g., materials). The increased number of borders can slow down the chemical and physical reaction occurring on the surface and inside of the coating. This speed reduction ultimately can result in postponed oxidation (corrosion) of critical areas like solder points, especially areas of increased electrical potential.

Certain hearing instruments have utilized 1H,1H,2H,2H-perfluorodecyl acrylate, for example CAS: 27905-45-9, as a single hydrophobic layer for creating a protective layer. However, recent regulations published by the European Union are banning this material. The disclosed hearing instrument may reduce and/or eliminate the use of 1H,1H,2H,2H-perfluorodecyl acrylate.

The hearing instrument may comprise a hearing aid, e.g. a hearing instrument adapted for being located at the ear or fully or partially in the ear canal of a user, e.g. a headset, an earphone, an ear protection device or a combination thereof. A hearing system may comprise a speakerphone (comprising a number of input transducers and a number of output transducers, e.g. for use in an audio conference situation), e.g. comprising a beamformer filtering unit, e.g. providing multiple beamforming capabilities. The hearing instrument can be a behind-the-ear (BTE) hearing aid. The hearing instrument can be an in-the-canal (ITC) hearing aid. The hearing instrument can be a receiver-in-the-ear (RITE) hearing aid.

The hearing instrument may be adapted to provide a frequency dependent gain and/or a level dependent compression and/or a transposition (with or without frequency compression) of one or more frequency ranges to one or more other frequency ranges, e.g. to compensate for a hearing impairment of a user. The hearing instrument may comprise a signal processor for enhancing the input signals and providing a processed output signal.

The hearing instrument may comprise an output unit for providing a stimulus perceived by the user as an acoustic signal based on a processed electric signal. The output unit may comprise a number of electrodes of a cochlear implant (for a CI type hearing aid) or a vibrator of a bone conducting hearing aid. The output unit may comprise an output transducer. The output transducer may comprise a receiver (loudspeaker) for providing the stimulus as an acoustic signal to the user (e.g. in an acoustic (air conduction based) hearing aid). The output transducer may comprise a vibrator for providing the stimulus as mechanical vibration of a skull bone to the user (e.g. in a bone-attached or bone-anchored hearing aid). The output unit may (additionally or alternatively) comprise a transmitter for transmitting sound picked up-by the hearing instrument to another device, e.g. a far-end communication partner (e.g. via a network, e.g. in a telephone mode of operation, or in a headset configuration).

The hearing instrument may comprise an input unit for providing an electric input signal representing sound. The input unit may comprise an input transducer, e.g. a microphone, for converting an input sound to an electric input signal. The input unit may comprise a wireless receiver for receiving a wireless signal comprising or representing sound and for providing an electric input signal representing said sound.

The hearing instrument may comprise a directional microphone system adapted to spatially filter sounds from the environment, and thereby enhance a target acoustic source among a multitude of acoustic sources in the local environment of the user wearing the hearing instrument. The directional system may be adapted to detect (such as adaptively detect) from which direction a particular part of the microphone signal originates. This can be achieved in various different ways as e.g. described in the prior art. In hearing instruments, a microphone array beamformer is often used for spatially attenuating background noise sources. The beamformer may comprise a linear constraint minimum variance (LCMV) beamformer. Many beamformer variants can be found in literature. The minimum variance distortionless response (MVDR) beamformer is widely used in microphone array signal processing. Ideally the MVDR beamformer keeps the signals from the target direction (also referred to as the look direction) unchanged, while attenuating sound signals from other directions maximally.

The hearing instrument may comprise antenna and transceiver circuitry allowing a wireless link to an entertainment device (e.g. a TV-set), a communication device (e.g. a telephone), a wireless microphone, or another hearing instrument, etc. The hearing instrument may thus be configured to wirelessly receive a direct electric input signal from another device. Likewise, the hearing instrument may be configured to wirelessly transmit a direct electric output signal to another device. The direct electric input or output signal may represent or comprise an audio signal and/or a control signal and/or an information signal.

The hearing instrument may be or form part of a portable (i.e. configured to be wearable) device, e.g. a device comprising a local energy source, e.g. a battery, e.g. a rechargeable battery. The hearing instrument may e.g. be a low weight, easily wearable, device, e.g. having a total weight less than 100 g, such as less than 20 g.

The hearing instrument may comprise a 'forward' (or `signal') path for processing an audio signal between an input and an output of the hearing instrument. A signal processor may be located in the forward path. The signal processor may be adapted to provide a frequency dependent gain according to a user's particular needs (e.g. hearing impairment). The hearing instrument may comprise an 'analysis' path comprising functional components for analyzing signals and/or controlling processing of the forward path. Some or all signal processing of the analysis path and/or the forward path may be conducted in the frequency domain, in which case the hearing instrument comprises appropriate analysis and synthesis filter banks. Some or all signal processing of the analysis path and/or the forward path may be conducted in the time domain.

The hearing instrument may comprise an analogue-to-digital (AD) converter to digitize an analogue input (e.g. from an input transducer, such as a microphone) with a predefined sampling rate, e.g. 20 kHz. The hearing instruments may comprise a digital-to-analogue (DA) converter to convert a digital signal to an analogue output signal, e.g. for being presented to a user via an output transducer.

The hearing instrument may comprise a number of detectors configured to provide status signals relating to a current physical environment of the hearing instrument (e.g. the current acoustic environment), and/or to a current state of the user wearing the hearing instrument, and/or to a current state or mode of operation of the hearing instrument. Alternatively or additionally, one or more detectors may form part of an *external* device in communication (e.g. wirelessly) with the hearing instrument. An external device may e.g. comprise another hearing instrument, a remote control, and audio delivery device, a telephone (e.g. a smartphone), an external sensor, etc. The number of detectors may comprise a movement detector, e.g. an acceleration sensor. The movement detector may be configured to detect movement of the user's facial muscles and/or bones, e.g. due to speech or chewing (e.g. jaw movement) and to provide a detector signal indicative thereof.

Embodiments of the disclosed hearing instrument can have improved corrosion protection. Embodiments of the disclosed hearing instrument can have improved deterioration protection. Embodiments of the disclosed hearing instrument can have improved oxidation protection. In particular, the disclosed hearing instrument can include a coating which prevents the infiltration of harmful material into the substrate. For example, embodiments of the disclosed hearing instrument can protect against the ingress of corrosive materials, such as human secretions. In particular, the corrosive materials can be prevented from interactions with metals in the hearing instrument. This can increase the longevity of the hearing instrument and prevent unwanted failure.

Corroding substances can be understood as any substance which may detrimentally affect the operation of components of the hearing instrument. Corroding substances can be understood as substances that can damage the hearing instrument.

Embodiments of the disclosed hearing instrument can have one or more substrates (e.g., be made of one or more substrates). The substrate can be any component of the hearing instrument. For example, substrates can include one or more of housings, wires, electronics, circuit boards, connectors, solder points, metals, and plastics. A substrate may have one or more additional components attached and/or embedded. For example, a circuit board may be formed of electronic components embedded onto a substrate. The substrate can be a surface of the hearing instrument. The substrate can be an electronic assembly of a hearing instrument. Further example of substrates can be formed of and/or include one or more of the output unit, the loudspeaker, the input unit, the directional microphone, the circuitry, the battery, and the detectors. The substrate can include one or more of acoustical units, electrical units, and mechanical units.

The coating can at least partially cover the substrate. The coating can fully cover an external facing substance of the substrate. In some examples, the coating can cover portions of the hearing instrument that may interact with corroding substances. The coating can vary thickness on the substrate. The coating can be configured to be applied at any time during the manufacture of the hearing instrument. As an example, components of the hearing instrument that are located in a user's hearing canal can be coated by the coating.

As used herein, the coating can be composed of sets of alternating layers. The alternating layers can include a border (e.g., interface) between layers of the alternating layers. For example, the alternating layers can be composed of a first layer and a second layer. The first layer and the second layer can have a first border between the first layer and the second layer.

A set of alternating layers can be understood to be a first layer and a second layer. In some examples, a set of alternating layers can be understood to be two layers. In certain examples, the alternating aspect of the alternating layers can occur when having two or more sets of alternating layers. The first layer and the second layer may have a border (e.g., boundary) between them. Two sets of alternating layers can be understood as a primary first layer, a primary second layer, a secondary first layer, and a secondary second layer. In some examples, two sets of alternating layers can be understood to be four layers. For example, the first layers and the second layers are alternating, meaning that the first layer and the second layer repeat in order. For example, three sets of alternating layers can be understood as a primary first layer, a primary second layer, a secondary first layer, a secondary second layer, a tertiary first layer, and a tertiary second layer.

The first layer (e.g., all the first layers such as the primary first layer, secondary first layer, tertiary first layer, etc.) can be composed of the same material (e.g., the first material). There may be minor variations between the different first layers, such as due to manufacturing tolerances, etc.

The second layer (e.g., all the first layers such as the primary second layer, secondary second layer, tertiary second layer, etc.) can be composed of the same material (e.g., the second material). There may be minor variations between the different first layers, such as due to manufacturing tolerances, etc.

In some examples, different first layers can be different materials having similar properties. For example, a primary first layer may be a first dielectric material and a secondary first layer may be a second dielectric material. In some examples, different second layers can be different materials having similar properties. For example, a primary second layer may be a first hydrophobic material and a secondary second layer may be a second hydrophobic material.

In other words, sets of alternating layers can be understood as being repeating layers of the first material and the second material. Each layer, and therefore each material, can form a border and/or interface with an adjacent layer. The alternating layers can form a stack of alternating layers. The sets of alternating layers can form the coating.

The first material can be a dielectric material. The first material can be a material with dielectric properties. In other words, the first material can function as an electrical insulator. In certain embodiments, the dielectric material can be polarized. In other embodiments, the dielectric material may not be polarized. In one or more examples or embodiments, the dielectric material is polyethylene. The dielectric material may allow for adhesion between the first material and the second material and/or the substrate. The dielectric material may be high density PE. The dielectric material may be one or more of: ethylene vinyl alcohol, polyvinyl chloride, polystyrene, and polypropylene.

The second material can be a hydrophobic material. The second material can be a material with hydrophobic properties. In other words, the second material can be configured to repel water. In some examples, the second material can be a material formed from nonpolar elements. The hydrophobic material can be configured to make a surface that is resistant to deposition of corrosive materials.

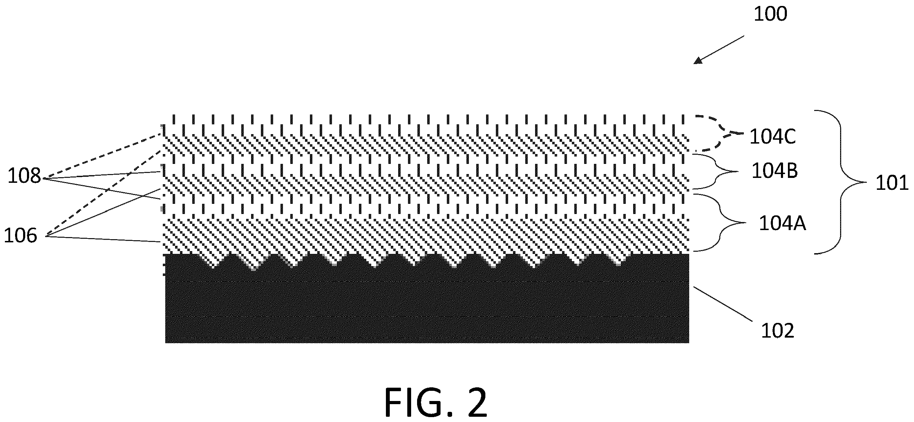

When a liquid droplet interacts with a surface the interaction can be described with terms such as wetting, spreading, adhesion and de-wetting. Wettability describes the interaction when a liquid first meets a solid surface. Wettability is a degree of wetting that is determined by a force balance of adhesive and cohesive forces, where adhesive forces are the forces between the molecules in the droplet and the surface and the cohesive forces are between molecules in each material separately. The term wetting refers to the study of how a droplet is spread out, or not spread out, on a surface and its ability to maintain contact with the surface. One definition of wettability expresses that wetting of a surface by a liquid can be described by the shape of the droplet and the droplets contact angle. The contact angle is also called Young's angle or the static contact angle and is derived from the tangential angle at the solid-liquid-air interface. The location, where these three substances (the solid, the liquid and the air) meet is also called the contact line. How the surface is wetted by the liquid is also directly related to the surface energy, where surfaces with low energy will show large contact angles. Surface energy is caused by the disruption of intermolecular bonds that occur when a surface is created. These are related to the surface (S), gas (G) and liquid (L). Together, these three surface energies γ form the shape of the droplet. The contact angle can be used to determine if a surface is hydrophobic or hydrophilic, where a hydrophobic surface has a contact angle larger than 90° and a hydrophilic surface an contact angle below 90° (as in FIG. 2). In addition, a superhydrophobic surface can be roughly defined as a surface having a contact angle larger than 150°.

In one or more example hearing instruments, the hydrophobic material is a perfluorinated material. In one or more example hearing instruments, the perfluorinated material includes perfluorooctyl acrylate. In one or more example hearing instruments, the perfluorinated material comprises 1H,1H,2H,2H-perfluorooctyl acrylate. In one or more example hearing instruments, the perfluorinated material comprises perfluorodecyl acrylate. In one or more example hearing instruments, the perfluorinated material comprises 1H,1H,2H,2H-perfluorodecyl acrylate. An example perfluorodecyl acrylate is CAS: 17527-29-6.

While 1H,1H,2H,2H-perfluorooctyl acrylate may have the best hydrophobic properties, the upcoming ban on the material makes it difficult for use. Accordingly, less hydrophobic materials may be used, such as 1H,1H,2H,2H-perfluorodecyl acrylate. Embodiments of the disclosed hearing instrument may use these types of lower hydrophobic materials and achieve the same, or even higher, corrosion resistance than 1H,1H,2H,2H-perfluorooctyl acrylate alone. 1H,1H,2H,2H-perfluorooctyl acrylate incorporated into the coating of the disclosure can also achieve high corrosion resistance.

In one or more example hearing instruments, the hearing instrument comprises three sets of the alternating layers. However, the number of sets of alternating layers is not limiting. For example, the hearing instrument could include four sets of alternating layers, five sets of alternating layers, etc. The number of sets of alternating layers can vary depending on any underlying components of the substrate and/or the location of the hearing instrument. For example, a substrate having sensitive electronics may have more sets of alternating layers than another substrate. As another example, a substrate configured to be located in the ear canal of a user may include more sets of layers than a substrate configured to be located behind-the-ear of a user.

In one or more example hearing instruments, the number of sets of layers may be the same over the hearing instrument. In one or more examples, the number of sets of layers may vary over different substrates of the hearing instrument.

In one or more example hearing instruments, the coating can have a thickness of 400-1200 nm. In one or more example hearing instruments, the coating can have a thickness of 800-900 nm. In some examples, the coating varies in thickness around the substrate. In some examples, the coating can have the same thickness around the substrate. In some examples, the coating can have a thickness of 800 nm ± 400 nm.

In one or more examples, the thickness of the first layer can be double the thickness of the second layer. For example, the first layer can have a thickness of 200 nm and the second layer can have a thickness of 100. Therefore, two sets of alternating layers can have a thickness of 600 nm. Three sets of alternating layers can have a thickness of 900 nm. In one or more examples, the thickness of the first layer can be the same (e.g., generally the same) as the thickness of the second layer.

In one or more example hearing instruments, the substrate comprises electrical components and/or solder points. The substrate may include sensitive components that may be affected by corrosion. Further, solder points can be structural weak, and therefore it can be advantageous to protect them from corrosion.

In one or more example hearing instruments, at least one of the alternating layers including the dielectric material is in contact with the substrate. For example, the primary first layer may be a dielectric material in contact with the substrate. In other words, a first layer of the two sets of alternating layers can be in contact with the substrate.

The hearing instrument may further comprise other relevant functionality for the application n question, e.g. compression, noise reduction, etc.

### Use:

In an aspect, use of a hearing instrument as described above, in the `detailed description of embodiments' and in the claims, is moreover provided. Use may be provided in a system comprising one or more hearing instruments (e.g. hearing aids), headsets, earphones, active ear protection systems, etc., e.g. in handsfree telephone systems, teleconferencing systems (e.g. including a speakerphone), public address systems, karaoke systems, classroom amplification systems, etc.

### A method:

In an aspect, a method of applying a corrosion-resistant coating to a hearing instrument is disclosed. The method includes applying a primary first layer onto a substrate, wherein the primary first layer comprises a first material comprising a dielectric material. The method includes applying a primary second layer onto the primary first layer, wherein the primary second layer comprises a second material comprising a hydrophobic material. The method includes applying a secondary first layer onto the primary second layer, wherein the secondary first layer comprises the first material. The method includes applying a secondary second layer onto the secondary first layer, wherein the secondary second layer comprises the second material.

The method can be used to apply (e.g., deposit, place) a coating. The method can be used to apply a coating on any number of hearing instruments, such as the ones discussed in detail above. The method can be used to apply a coating to any number of components (e.g., substrates) of a hearing instrument.

In one or more example methods, applying one or more of the primary first layer, the primary second layer, the secondary first layer, and the secondary second layer comprises applying via a plasma enhanced chemical vapor deposition (PECVD). In certain implementations, other application and/or deposition methods can be performed.

In one or more example methods, the method can further include applying a tertiary first layer onto the secondary second layer, wherein the tertiary first layer comprises the first material. In one or more example methods, the method can further include applying a tertiary second layer onto the tertiary first layer, wherein the tertiary second layer comprises the second material.

In one or more example methods, the dielectric material is polyethylene and/or wherein the hydrophobic material is a perfluorinated material. In one or more example methods, the perfluorinated material comprises perfluorooctyl acrylate. In one or more example methods, the perfluorinated material comprises 1H,1H,2H,2H-perfluorooctyl acrylate. In one or more example methods, the perfluorinated material comprises perfluorodecyl acrylate. In one or more example methods, the perfluorinated material comprises 1H,1H,2H,2H-perfluorodecyl acrylate.

It is intended that some or all of the structural features of the device described above, in the `detailed description of embodiments' or in the claims can be combined with embodiments of the method, when appropriately substituted by a corresponding process and vice versa. Embodiments of the method have the same advantages as the corresponding devices.

### Definitions:

In the present context, a hearing instrument, e.g. a hearing aid, refers to a device, which is adapted to improve, augment and/or protect the hearing capability of a user by receiving acoustic signals from the user's surroundings, generating corresponding audio signals, possibly modifying the audio signals and providing the possibly modified audio signals as audible signals to at least one of the user's ears. Such audible signals may e.g. be provided in the form of acoustic signals radiated into the user's outer ears, acoustic signals transferred as mechanical vibrations to the user's inner ears through the bone structure of the user's head and/or through parts of the middle ear as well as electric signals transferred directly or indirectly to the cochlear nerve of the user.

The hearing instrument may be configured to be worn in any known way, e.g. as a unit arranged behind the ear with a tube leading radiated acoustic signals into the ear canal or with an output transducer, e.g. a loudspeaker, arranged close to or in the ear canal, as a unit entirely or partly arranged in the pinna and/or in the ear canal, as a unit, e.g. a vibrator, attached to a fixture implanted into the skull bone, as an attachable, or entirely or partly implanted, unit, etc. The hearing instrument may comprise a single unit or several units communicating (e.g. acoustically, electrically or optically) with each other. The loudspeaker may be arranged in a housing together with other components of the hearing instrument or may be an external unit in itself (possibly in combination with a flexible guiding element, e.g. a dome-like element).

A hearing instrument may be adapted to a particular user's needs, e.g. a hearing impairment. A configurable signal processing circuit of the hearing instrument may be adapted to apply a frequency and level dependent compressive amplification of an input signal. A customized frequency and level dependent gain (amplification or compression) may be determined in a fitting process by a fitting system based on a user's hearing data, e.g. an audiogram, using a fitting rationale (e.g. adapted to speech). The frequency and level dependent gain may e.g. be embodied in processing parameters, e.g. uploaded to the hearing instrument via an interface to a programming device (fitting system) and used by a processing algorithm executed by the configurable signal processing circuit of the hearing instrument.

A 'hearing system' refers to a system comprising one or two hearing instruments, and a `binaural hearing system' refers to a system comprising two hearing instruments and being adapted to cooperatively provide audible signals to both of the user's ears. Hearing systems or binaural hearing systems may further comprise one or more `auxiliary devices', which communicate with the hearing instrument(s) and affect and/or benefit from the function of the hearing instrument(s). Such auxiliary devices may include at least one of a remote control, a remote microphone, an audio gateway device, an entertainment device, e.g. a music player, a wireless communication device, e.g. a mobile phone (such as a smartphone) or a tablet or another device, e.g. comprising a graphical interface. Hearing instruments, hearing systems or binaural hearing systems may e.g. be used for compensating for a hearing-impaired person's loss of hearing capability, augmenting or protecting a normal-hearing person's hearing capability and/or conveying electronic audio signals to a person. Hearing instruments or hearing systems may e.g. form part of or interact with public-address systems, active ear protection systems, handsfree telephone systems, car audio systems, entertainment (e.g. TV, music playing or karaoke) systems, teleconferencing systems, classroom amplification systems, etc.

### BRIEF DESCRIPTION OF DRAWINGS

The aspects of the disclosure may be best understood from the following detailed description taken in conjunction with the accompanying figures. The figures are schematic and simplified for clarity, and they just show details to improve the understanding of the claims, while other details are left out. Throughout, the same reference numerals are used for identical or corresponding parts. The individual features of each aspect may each be combined with any or all features of the other aspects. These and other aspects, features and/or technical effect will be apparent from and elucidated with reference to the illustrations described hereinafter in which:
- FIGS. 1A-1B: show embodiments of hearing instruments according to the disclosure;
- FIG. 2: shows an example hearing instrument with a coating according to the disclosure;
- FIGS. 3A-3B: show example corrosion penetration of a hearing instrument; and
- FIG. 4: shows a method of applying a corrosion resistant coating according to the disclosure.

The figures are schematic and simplified for clarity, and they just show details which are essential to the understanding of the disclosure, while other details are left out. Throughout, the same reference signs are used for identical or corresponding parts.

Further scope of applicability of the present disclosure will become apparent from the detailed description given hereinafter. However, it should be understood that the detailed description and specific examples, while indicating preferred embodiments of the disclosure, are given by way of illustration only. Other embodiments may become apparent to those skilled in the art from the following detailed description.

### DETAILED DESCRIPTION OF EMBODIMENTS

The detailed description set forth below in connection with the appended drawings is intended as a description of various configurations. The detailed description includes specific details for the purpose of providing a thorough understanding of various concepts. However, it will be apparent to those skilled in the art that these concepts may be practiced without these specific details. Several aspects of the apparatus and methods are described by various blocks, functional units, modules, components, circuits, steps, processes, algorithms, etc. (collectively referred to as "elements"). Depending upon particular application, design constraints or other reasons, these elements may be implemented using electronic hardware, computer program, or any combination thereof.

The electronic hardware may include substrates including (e.g., made up of) micro-electronic-mechanical systems (MEMS), integrated circuits (e.g. application specific), microprocessors, microcontrollers, digital signal processors (DSPs), field programmable gate arrays (FPGAs), programmable logic devices (PLDs), gated logic, discrete hardware circuits, printed circuit boards (PCB) (e.g. flexible PCBs), and other suitable hardware configured to perform the various functionality described throughout this disclosure, e.g. sensors, e.g. for sensing and/or registering physical properties of the environment, the device, the user, etc.

The present application relates to the field of hearing instruments.

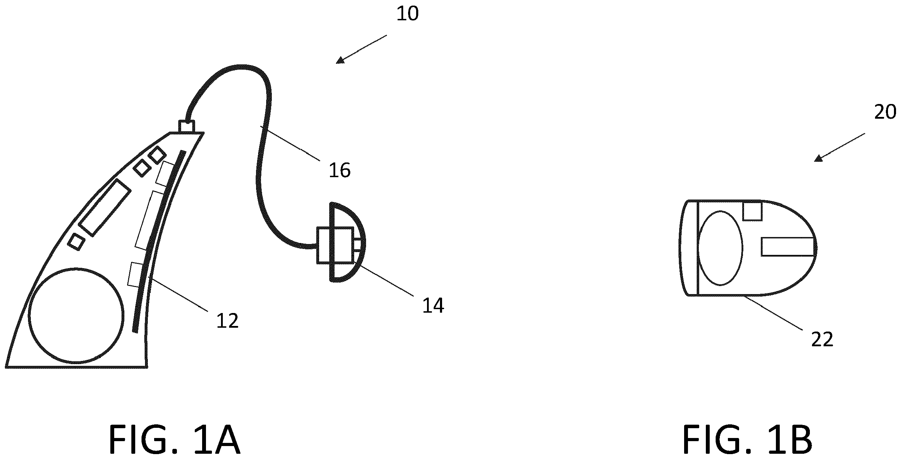

FIGS. 1A-1B show example hearing instruments according to embodiments of the disclosure. FIG. 1A illustrates an example behind-the-ear (BTE) hearing instrument. The hearing instrument 10 is configured to be worn behind the user's ear and comprises a behind-the-ear part 12 and an in-the-ear part 14. The behind-the-ear part 12 is connected to the in-the-ear part 14 via connecting member 16. However, the hearing instrument may be configured in other ways e.g., as completely-in-the-ear (ITE) hearing instrument 20 as shown in FIG. 1B. The ITE hearing instrument 20 can include only an in-the-ear part 22. Portions of the BTE hearing instrument 10 and/or the ITE hearing instrument 20 can include the coating as described herein. For example, for the BTE hearing instrument 10, the substrate can be portions of the behind-the-ear part 12, the in-the-ear part 14, and the connecting member 16.

The hearing instruments 10,20 can include an input unit, an output unit, a man-machine interface unit, a memory, a wireless communication unit (WLC unit), a battery and a processor. Any and/or all of these components can be covered by the coating as described herein. For example, any and/or all of these components can be the substrate.

The input unit is configured to generate an input signal representing sound. The input unit may comprise an input transducer, e.g., one or more microphones, for converting an input sound to the input signal. The input unit may comprise a wireless receiver for receiving a wireless signal comprising or representing sound and for providing the signal representing sound. The coating described herein can be applied to the components of the input unit.

The output unit may comprise an output transducer. The output transducer may comprise a loudspeaker (sometimes denoted a receiver) for providing an acoustic signal to the user of the hearing instrument. The output unit may, additionally or alternatively, comprise a transmitter for transmitting sound picked up by the hearing instrument to another device. The coating described herein can be applied to the components of the output unit.

The coating can be further applied to any other substrates and/or component of the hearing instruments 10, 20.

FIG. 2 shows an example hearing instrument 100 with a coating 101 according to the disclosure. The coating 101 can be used to improve corrosion protection of the hearing instrument 100. The hearing instrument 100 can be, for example, the hearing instruments 10, 20 discussed with respect to FIGS. 1A-1B.

As shown, the coating 101 can be applied (e.g., deposited, placed, located) on a substrate 102 of the hearing instrument 100. The coating 101 can at least partially cover the substrate 102. The substrate 102 can include electrical components and/or solder points, which can be advantageous in protection from corrosion.

FIG. 2 shows a coating 101 made up of at least two sets of alternating layers, specifically set 104A and set 104B. FIG. 2 also shows an optional third set 104C. As shown, each of the sets 104A, 104B, 104C of alternating layers includes a first layer 106 being a first material and a second layer 108 being a second material. The first material (e.g., first layer 106) includes a dielectric material. The second material (e.g., second layer 108) includes a dielectric material.

As shown in FIG. 2, the sets of alternating layers 104A, 104B, 104C forms a repeating pattern of the first layer 106 and second layer 108. Further, the first layer 106 can be in contact with the substrate 102. The coating 101 (including the sets of alternating layers 104A, 104B, 104C) can have a thickness of 400-1200nm.

Different materials can be used for the dielectric material and the hydrophobic material. For example, the dielectric material could be polyethylene. The hydrophobic material could be a perfluorinated material. Perfluorinated materials can include perfluorooctyl, such as 1H,1H,2H,2H-perfluorooctyl acrylate and perfluorodecyl acrylate, such as 1H,1H,2H,2H-perfluorodecyl acrylate.

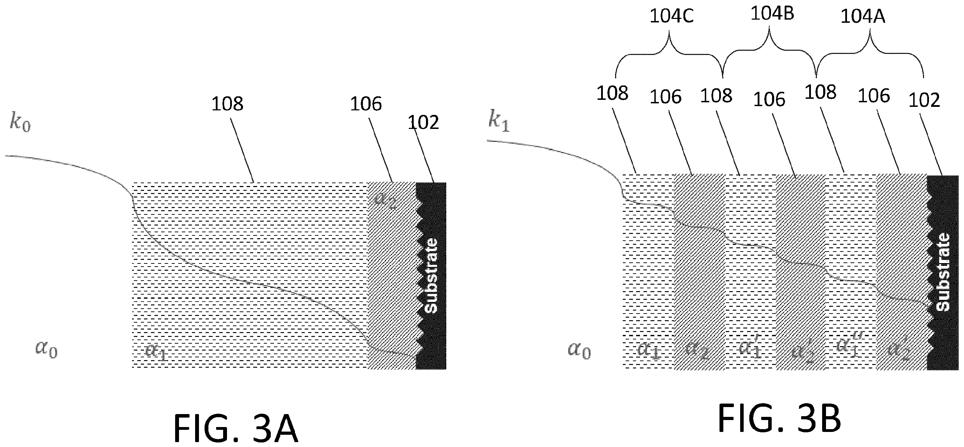

FIGS. 3A-3B show example corrosion penetration of a hearing instrument. In particular, FIGS. 3A-3B show permeability of human secretions though a single set of alternating layers (FIG. 3A) as compared to the two sets of alternating layers (FIG. 3B) according to the disclosure. FIGS. 3A-3B illustrate a coating having the same thickness, though different thicknesses of layers can be used.

As shown, the two sets of alternating layers 104A, 104B and optionally 104C of FIG. 3B according to the disclosure results in significantly less penetration to the substrate 102 than the single set of FIG. 3A. As shown, the sets of alternating layers 104A, 104B, and optionally 104C can be formed of a first layer 106 and a second layer 108. Accordingly, the disclosure introduces increased functionality and performance of the coating by delivering reduced physical and chemical permeability. The increased number of sets of alternating layers leads to an increased number of borders (e.g., boundaries) between phases (e.g., layers, materials), which slows down moving boundary of the chemical and physical reaction occurring on the surface and inside of the coating. This speed reduction ultimately results in postponed oxidation (corrosion) of critical areas like solder points, especially areas of increased electrical potential. For example, every boundary makes the permeability of fluids/secretions lower. This can increase the time before secretions gets in contact with components of the hearing instrument, such as solder points.

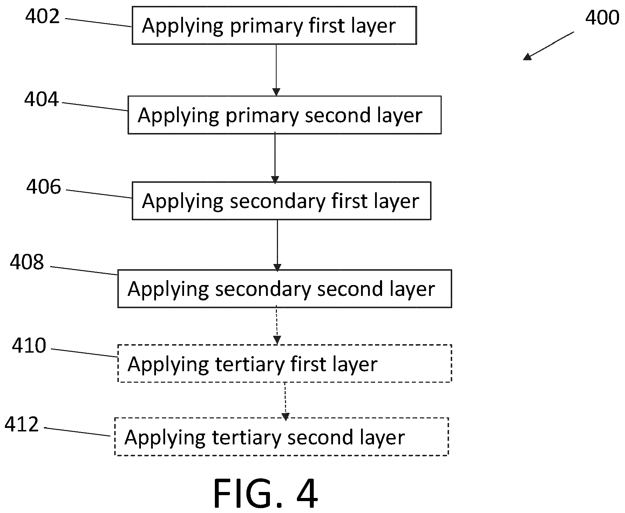

FIG. 4 shows a method 400 of applying a corrosion resistant coating to a hearing instrument according to the disclosure. As shown, the method includes applying 402 a primary first layer onto a substrate, wherein the primary first layer comprises a first material comprising a dielectric material. The method 400 can include applying 404 a primary second layer onto the primary first layer, wherein the primary second layer comprises a second material comprising a hydrophobic material. The method 400 can include applying 406 a secondary first layer onto the primary second layer, wherein the secondary first layer comprises the first material. The method 400 can include applying 408 a secondary second layer onto the secondary first layer, wherein the secondary second layer comprises the second material. Optionally, the method 400 can include applying 410 a tertiary first layer onto the secondary second layer, wherein the tertiary first layer comprises the first material. Further, the method 400 can optionally include applying 412 a tertiary second layer onto the tertiary first layer, wherein the tertiary second layer comprises the second material.

The different layers can be applied via deposition techniques. For example, applying one or more of the primary first layer, the primary second layer, the secondary first layer, and the secondary second layer can include applying via a plasma enhanced chemical vapor deposition (PECVD).

It is intended that the structural features of the devices described above, either in the detailed description and/or in the claims, may be combined with steps of the method, when appropriately substituted by a corresponding process.

As used, the singular forms "a," "an," and "the" are intended to include the plural forms as well (i.e. to have the meaning "at least one"), unless expressly stated otherwise. It will be further understood that the terms "includes," "comprises," "including," and/or "comprising," when used in this specification, specify the presence of stated features, integers, steps, operations, elements, and/or components, but do not preclude the presence or addition of one or more other features, integers, steps, operations, elements, components, and/or groups thereof. It will also be understood that when an element is referred to as being "connected" or "coupled" to another element, it can be directly connected or coupled to the other element, but an intervening element may also be present, unless expressly stated otherwise. Furthermore, "connected" or "coupled" as used herein may include wirelessly connected or coupled. As used herein, the term "and/or" includes any and all combinations of one or more of the associated listed items. The steps of any disclosed method are not limited to the exact order stated herein, unless expressly stated otherwise.

It should be appreciated that reference throughout this specification to "one embodiment" or "an embodiment" or "an aspect" or features included as "may" means that a particular feature, structure or characteristic described in connection with the embodiment is included in at least one embodiment of the disclosure. Furthermore, the particular features, structures or characteristics may be combined as suitable in one or more embodiments of the disclosure. The previous description is provided to enable any person skilled in the art to practice the various aspects described herein. Various modifications to these aspects will be readily apparent to those skilled in the art, and the generic principles defined herein may be applied to other aspects.

The claims are not intended to be limited to the aspects shown herein but are to be accorded the full scope consistent with the language of the claims, wherein reference to an element in the singular is not intended to mean "one and only one" unless specifically so stated, but rather "one or more." Unless specifically stated otherwise, the term "some" refers to one or more.

## Claims

1. A hearing instrument (100) having improved corrosion protection, the hearing instrument (100) comprising:
a substrate (102); and
a coating (101) at least partially covering the substrate (102), the coating (101) comprising at least two sets of alternating layers (104A, 104B), a first layer (106) of the alternating layers (104A, 104B) comprising a first material and a second layer (108) of the alternating layers (104A, 104B) comprising a second material;
wherein the first material comprises a dielectric material comprising polyethylene; and
wherein the second material comprises a hydrophobic material, wherein hydrophobic material comprises 1H,1H,2H,2H-perfluorodecyl acrylate.

2. The hearing instrument of claim 1, wherein the hearing instrument (100) comprises three sets of the alternating layers (104A, 104B, 104C).

3. The hearing instrument of any one of the previous claims, wherein the coating (101) has thickness of 400-1200nm.

4. The hearing instrument of claim 3, wherein coating (101) has a thickness of 800-900nm.

5. The hearing instrument of any one of the previous claims, wherein a thickness of the first layer (106) is double the thickness of the second layer (108).

6. The hearing instrument of any one of the previous claims, wherein the substrate (102) comprises electrical components and/or solder points.

7. The hearing instrument of any one of the previous claims, wherein at least one of the alternating layers including the dielectric material is in contact with the substrate (102).

8. A method (400) of applying a corrosion-resistant coating to a hearing instrument, the method comprising:
applying (402) a primary first layer onto a substrate, wherein the primary first layer comprises a first material comprising a dielectric material comprising polyethylene;
applying (404) a primary second layer onto the primary first layer, wherein the primary second layer comprises a second material comprising a hydrophobic material comprising 1H,1H,2H,2H-perfluorodecyl acrylate;
applying (406) a secondary first layer onto the primary second layer, wherein the secondary first layer comprises the first material; and
applying (408) a secondary second layer onto the secondary first layer, wherein the secondary second layer comprises the second material.

9. The method of claim 8, wherein applying (402, 404, 406, 408) one or more of the primary first layer, the primary second layer, the secondary first layer, and the secondary second layer comprises applying via a plasma enhanced chemical vapor deposition (PECVD).

10. The method of any one of claims 8-9, further comprising:
applying (410) a tertiary first layer onto the secondary second layer, wherein the tertiary first layer comprises the first material; and
applying (412) a tertiary second layer onto the tertiary first layer, wherein the tertiary second layer comprises the second material.

11. The method of any one of claims 8-9, wherein applying the primary first layer, applying the primary second layer, applying the secondary first layer, and applying the secondary second layer forms a coating having a thickness of 400-1200nm.

12. The method of claim 11, wherein applying the primary first layer, applying the primary second layer, applying the secondary first layer, and applying the secondary second layer forms the coating having a thickness of 800-900nm.
